Europäisches Patentamt

(19) European Patent Office

Office européen des brevets

(11) Publication number: **0 150 403**
**B1**

(12) **EUROPEAN PATENT SPECIFICATION**

(45) Date of publication of patent specification: **03.08.88**

(21) Application number: **84115496.6**

(22) Date of filing: **14.12.84**

(51) Int. Cl.⁴: **H 01 L 21/90, H 01 L 23/52**

(54) **Multilevel metal structure and process for making same.**

(30) Priority: **27.12.83 US 565562**

(43) Date of publication of application:
**07.08.85 Bulletin 85/32**

(45) Publication of the grant of the patent:
**03.08.88 Bulletin 88/31**

(84) Designated Contracting States:
**DE FR GB**

(56) References cited:
**EP-A-0 046 525**
**US-A-3 985 597**
**US-A-4 001 870**

**PATENT ABSTRACTS OF JAPAN, vol. 6, no. 9, 20th January 1982, page (E-90) (887); & JP-A-56-130947 (FUJITSU K.K.) 14-10-1981**

(73) Proprietor: **International Business Machines Corporation**
**Old Orchard Road**
**Armonk, N.Y. 10504 (US)**

(72) Inventor: **Sachdev, Harbans Singh**
**14 Tanglewood Drive**
**Wappingers Falls, N. Y. 12590 (US)**
Inventor: **Sachdev, Krishna**
**14 Tanglewood Drive**
**Wappingers Falls, N. Y. 12590 (US)**

(74) Representative: **Oechssler, Dietrich, Dr.rer.nat. Dipl.-Chem.**
**Schönaicher Strasse 220**
**D-7030 Böblingen (DE)**

Courier Press, Leamington Spa, England.

## Description

The invention relates to a layered composite structure in an integrated circuit package having a substrate with a conductive interconnective first pattern on a surface thereof and a method of forming superposed levels of metallurgy in the fabrication of an integrated circuit package where said method starts from a substrate having a conductive interconnected pattern on a surface thereof.

Fabrication of large scale integrated circuits with dense networks of multilevel metal interconnections requires design/development of improved materials/processes in terms of compatibility of contiguous films in multilevel structures and reduced sensitivity to process tolerances. Also, in order to maintain processing groundrules and insure good coverage of metal and insulators at all levels, processes for planar surface topography are essential.

In U.S. Patent 3,985,597, a planar process for forming embedded interconnection metallurgy is described according to which a substrate is overcoated with a first layer of an organic thermosetting resin followed by a second polymeric layer removable by a solvent system without affecting the first layer, subsequent third layer resistant to reactive ion etching in oxygen and finally a top layer of a resist-material with sensitivity to e-beam, x-ray, UV or optical radiation. A desired metallurgy pattern in the resist-layer is defined by the usual lithographic process followed by reactive ion etching (RIE) to transfer the pattern into the third, the second and the first layer, blanket deposition of a conductive metal layer having a thickness approximately matching the thickness of the first layer, and finally a solvent soak to lift off the non-imaged composite structure selectively at the interphase of the first and second layer.

In U.S. Patent 4,367,119, an improved planar multilevel process using inorganic films such as silicon nitride, or silicon oxide as dual dielectric and built-in etch-stop is described for interconnection metallurgy system embedded in polyimide passivating layer with planar top surface.

According to the polyimide planar process of the aforesaid U.S. Patent, for the first level metallization, a polyimide film is first spin applied on a substrate and is cured up to 400°C. This is followed sequentially by a plasma enhanced chemically vapor deposited layer of silicon nitride as the etch stop, a polysulfone lift-off layer applied by spin coating and subsequently cured up to 300°C, $SiO_x$ or glass resin as a barrier layer and finally the resist layer. The via pattern is formed by the conventional lithographic technique followed by RIE in a $CF_4$ ambient to etch the $SiO_x$ layer, in $O_2$ to etch the polysulfone layer, again in $CF_4$ to etch the silicon nitride layer and finally in $O_2$ to etch the polyimide layer followed by in-situ sputter cleaning step, metal evaporation for the desired metallurgy, and lift-off by soaking in n-methylpyrrolidone (NMP) at 60° to 85°C. The process is then repeated for increasing levels of metallization. Although this strategy has several advantages, (e.g., overcoming the non-planarity problem that is generally encountered in the conventional lift-off methods, reduction of interlevel shorts and maintenance of desired insulator thickness between levels of metallization) it has the disadvantage of incompatibility of the organic-inorganic composite layers with consequent vulnerability of the structure to process-induced stresses causing product reliability concerns or failure of the process to provide defect/crack-free structures. For example, with polysulfone resin as the "lift-off" layer and silicon nitride as $O_2$ etch stop according to the process described in the above patent, it is observed that during the lift-off step which requires protracted soak in NMP at 85°C, the underlying polyimide layer swells due to solvent permeation invariably causing stress cracking of the overlying silicon nitride layer which is rigid and non-compliant.

It is the object of the invention to provide planar, crack-free multilevel metal structures embedded in passivating layers without interlevel shorts and a method for forming such structures that is relatively insensitive to process tolerances.

This object is achieved by a layered composite structure in an integrated circuit package having a substrate with a conductive interconnective first pattern on a surface thereof, said structure comprising:

a first layer of an organic polymer electrical insulator overlying said surface and said first pattern; and

a covering organosilicon insulating layer being resistant to reactive ion etching in an $O_2$ atmosphere and overlying said polymer layer; and

a second conductive pattern on said organometallic insulating layer; and

there being at least one via opening through said composite layered structure to a portion of said first pattern; and

conductive metallurgy in said via opening interconnecting the said first pattern and said second pattern,

and by a method of forming superposed levels of metallurgy in the fabrication of an integrated circuit package when said method starts from a substrate having a conductive interconnected pattern on a surface thereof and comprises the following steps in the following sequence:

A) forming a first layer of an electrically insulating polymer on said surface

B) coating said first layer with a second layer of a plasma deposited organosilicon insulating material selected from the group of divinyl tetramethyl disiloxane, hexamethyl disilazane, hexamethyl disiloxane, divinyl tetramethyl disilazane, trivinyl penta methyl trisiloxane or vinyl trimethoxysilane

C) coating said second layer with a third layer of a polymer that is selectively soluble in solvent to which the first said polymer is inert

D) coating said third layer with a fourth layer resistant to reactive ion etching in oxygen ambient

E) forming on said fourth layer a resist mask defining at least one via opening to a portion of said conductive pattern

F) reactive ion etching in CF$_4$ ambient the exposed portion of said fourth layer in said via opening

G) reactive ion etching in an oxygen ambient portions of said third layer in said via opening

H) reactive ion etching in a CF$_4$ or CHF$_3$ or mixture of CF$_4$ and O$_2$ ambient the exposed portions of said second layer in said via opening

I) reactive ion etching in O$_2$ ambient the exposed portion of said first layer in said via opening to expose said portion of said conductive pattern

J) blanket coating said substrate inclusive of said via opening with a conductive metal layer having thickness close to the said first layer

K) exposing said substrate to said solvent for a time sufficient to remove said third layer and all overlying layers thereon, to expose plasma deposited organosilicon insulating layer and said metal via connection in said via opening

L) sequentially coating said plasma deposited organosilicon layer with fifth, sixth and seventh layer corresponding respectively to the composition of said first, third and fourth layer

M) forming a second resist mask having openings corresponding to desired metallurgy patterns to be deposited on said plasma deposited organosilicon second layer, said opening encompassing said via connector and adjacent discrete areas of said plasma deposited second organosilicon layer

N) reactive ion etching in an ambient of CF$_4$ the exposed portions of said seventh layer in the openings of said second resist mask

O) sequentially reactive ion etching in O$_2$ ambient said sixth layer and said fifth layer in opening of said second resist mask, to expose said via connector and adjacent portions of said plasma deposited organosilicon second layer

P) depositing a blanket coating of a conductive metal over said substrate inclusive of said via connector and said adjacent exposed portion of said plasma deposited organosilicon layer

Q) exposing said substrate to a solvent selective to the said sixth layer for a time sufficient to remove said sixth layer including overlying layers thereon.

The inventive structure is relatively insensitive to process-induced stresses, provides more compatible composite structures for multilevel metal processes and also films, that are resistant to reactive ion etching in an oxygen containing atmosphere and are not affected by ambient humidity and shelf time.

The inventive method provides an improved strategy for the formation of metal interconnections in the fabrication of integrated circuits. The inventive method uses a compliant, solvent resistant but solvent permeable oxygen etch mask in a composite film structure which, unlike inorganic films such as silicon nitride or silicon oxide, does not undergo stress cracking in polar solvents such as NMP, DMF or diglyme. By applying thin barrier films which have lower pinhole density and enhanced solvent permeability than silicon nitride or silicon oxide an efficient escape of any residual volatiles during metal evaporation and an efficient removal of trapped solvents prior to high temperature process steps are guaranteed thereby eliminating conical stud formation or eliminating corrosion or darkening of metallurgy respectively. The application of the electrically non-conducting oxygen RIE resistant films in processes for forming multilevel metals has the further advantages, that these films are compatible with organic and inorganic substrates and are formed from relatively non-hazardous organosilicon monomers as opposed to potentially explosive SiH$_4$ and Si$_2$H$_6$ required for conventional barrier films such as silicon nitride or silicon oxide.

Essentially for the inventive method for building planar multilevel-metal-insulator system is the usage of plasma polymerized organosilicon films as dual-dielectric plus oxygen etch stop as replacement of conventional silicon nitride or silicon oxide. The methodology according to this invention provides crack-free metallized structures while having the advantages of inorganic barriers which provide protection against overetching, reduce interlevel shorts and maintain requisite insulator thickness between metallization levels.

For the overall process sequence to define various levels of metallization, a reference is made to the planar polyimide process with built-in etch-stop as described in U.S. Patent No. 4,367,119, which employs a thin plasma enhanced chemically vapor deposited silicon nitride as O$_2$ etch stop and dual dielectric.

The method of the present invention comprises depositing on a substrate (which can be silicon, glass, ceramic, silicon-silicon oxide) a thermosetting resin such as polyimide planar layer, preferably by applying two coats to obtain the desired thickness. This is done by application of the first coat which is then prebaked at 100°C for 30 minutes and then at 150°C for 15 minutes followed by the deposition of the second coat which is subjected to the prebake conditions of the first layer and then cured at 200°C for 15 minutes, 300°C for 15 minutes and finally to 400°C for 1 hour. This technique of polyimide application in two coats, with the first only partially cured, provides superior planarization and adhesion between polyimide layers.

Over the fully cured polyimide layer is deposited a thin film (50—200 nm) of plasma polymerized or plasma enhanced chemically vapor deposited organosilicon monomer such as divinyltetramethyl disiloxane (DVS), hexamethyldisiloxane (HMS), hexamethyldisilazane (HMDS) or vinyl trimethoxysilane (VTMS) or trivinyl pentamethyl trisiloxane (TVTS). The deposition of these barrier films can be carried out at ambient temperature when the films are subsequently annealed up to 250—400°C for 15 minutes to provide pinhole free, solvent resistant and thermally stable coatings. Deposition can also be carried out at elevated temperature preferably at 100°C—250°C using inductively-coupled or capacitively coupled plasma systems.

A polysulfone lift-off layer is then spin applied over the barrier layer, prebaked at 100°C for 10 minutes, 200°C for 15 minutes and 300°C for 30 minutes, and overcoated with a second barrier layer consisting of conventional materials such as $SiO_x$ "glass resin" or the plasma deposited organosilicons of the present invention, and finally a resist layer is applied by spin coating. After the necessary prebake of the resist coating, a desired metallurgy pattern is defined by the conventional lithographic process with e-beam, x-ray, UV or optical exposure. Typically, 1.5—2 micrometer film of a diazoquinone type resist such as AZ 1350J resist from Shipley Co. in Massachusetts is employed for this purpose. Reactive ion etching, (a) in a $CF_4$ ambient is employed to transfer the exposed pattern into the $SiO_x$ or equivalent barrier film, (b) in $O_2$ ambient to etch through the polysulfone layer, (c) in $CF_4$ or a mixture of $CF_4$ and $O_2$, or in $CHF_3$ to etch through the organosilicon barrier film and finally (d) in $O_2$ to etch the polyimide layer followed by an in-situ sputter clean step and blanket metal evaporation. The release of the lift-off mask is accomplished by the usual process involving 2—8 hours soak in n-methyl pyrrolidone (NMP) at 60—85°C to provide crack-free metallized via structure with the plasma deposited organosilicon film remaining firmly adhered to the underlying polyimide layer. Prior to defining second metal level, the post lift-off structure is heated at 85°C for 5 minutes, 200°C for 10 minutes and at 300°C for 10 minutes under nitrogen to insure removal of any trapped NMP. The process employed to construct further levels of metallization is similar to that described for the stud level, using plasma deposited organosilicon films as substitutes for silicon nitride and/or silicon oxide in the desired composite layer structure.

Although the use of plasma deposited divinyltetramethyl disiloxane, hexamethyldisiloxane, hexamethyldisilazane or vinyl trimethoxysilane is given here for etch stop or masking layer, other plasma deposited organosilicons described in the European Patent Application 114 229 can also be used for this invention.

In summary, the process relates to the construction of a planar multilevel-metal-insulator structure with a built-in etch stop layer of plasma deposited organosilicons. This etch-stop layer also serves as a dual dielectric between metal levels and reduces interlevel shorts. The technique of applying polyimide in two coats with deposition of the second coat on semicured first coat and subsequent full cure at 400°C provides planar structures. The overall process/materials of this invention is compatible with conventional semiconductor fabrication techniques.

Other advantageous embodiments of the inventive structure and the inventive method are disclosed in the subclaims.

The invention becomes more apparent from the following detailed description taken in conjunction with the accompanying drawings 1 through 13 illustrating the steps in the process for forming metallurgical patterns on a substrate and the product formed thereby.

Background information relevant to this invention is described in U.S. Patent 3,985,597 and U.S. Patent 4,367,119, the disclosures of which are incorporated herein by this reference as if they were reproduced in their entirety.

While being broadly useful in a variety of applications including protective coatings for passivation and encapsulation, anti-reflection coatings in conventional optics, thin light wave guides and moisture barrier films for alkali halide optics, the plasma deposited organosilicon films are employed according to the present invention as oxygen reactive ion etch (RIE) resistant coatings with organic or inorganic contacting layers in multilevel metal processes for high density integrated circuits. The preferred coatings of this invention have (1) high silicon to carbon ratio, (2) thermal stability up to above 400°C, (3) resistance to commonly employed processing solvents such as diglyme, NMP, chlorobenzene, cyclohexanone, etc., (4) resistance to reactive ion etching in $O_2$ ambient, (5) etchable by reactive ion etch in $CF_4$ or $CHF_3$ ambient or buffered HF at rates comparable to the conventional barriers such as silicon nitride or silicon oxide, (6) organosilicon monomers with boiling points and vapor pressure in a convenient enough range to allow vaporization and provide high deposition rates using inductively or capacitively coupled plasma systems, (7) the organosilicon monomers with loweset possible toxicity or other safety related factors, and (8) desired functional characteristics of the films including mechanical/electrical properties, adhesion to contiguous organic, inorganic or metallic layers and compatibility in terms of thermal expansion coefficients with contacting polymer layers.

The following sequence of steps describes the process/materials of the present invention for forming a multilevel metal interconnection metallurgy system embedded in a passivating layer.

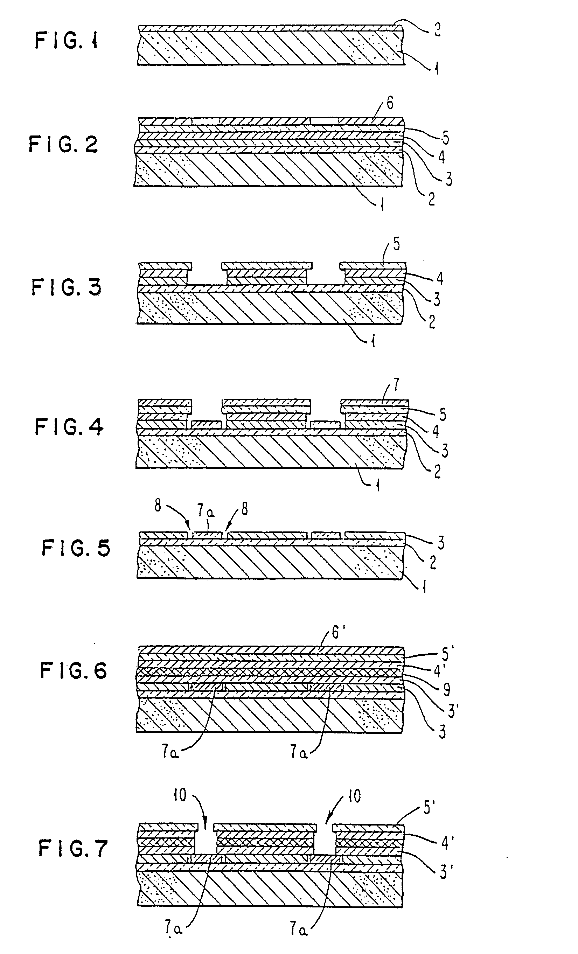

Fig. 1 shows a substrate 1 which is typically a semiconductor nonocrystalline silicon or a ceramic substrate with metal lines with an overlying layer 2 of a dielectric as for example $SiO_2$, $Si_3N_4$, $SiO_x$, $Ta_2O_5$. The substrate 1 of the invention is an integrated circuit device having active and passive devices fabricated therein (not shown) which are suitably isolated from each other. The dielectric layer 2 is provided with appropriate contact openings (not shown here) for making electrical contact with devices underneath. For application to packaging, the substrate could also be glass or ceramic with metallurgy for supporting integrated circuit devices and appropriate associated circuitry.

As shown in Fig. 2, a layer 3 of an insulator organic resin is deposited over layer 2. The material of layer 3, which can have thickness of

1—5 μm (microns), can be any suitable dielectric that will have good adhesion to 2. An adhesion promoter such as γ-aminopropyltriethoxy silane (A-1100) is applied by vapor deposition or spray or spin coating of a dilute (0.1%) solution from ethanol, methanol or water. The preferred material for layer 3 is a polyimide derived from pyromellitic dianhydride and oxydianiline manufactured by duPont and sold under the trade name Pyralin (RC-5878). The resin is used as a polyamic acid solution which is applied in two or three coats depending upon the thickness required. Before final cure at 400°C for 30 min to one hour, the initial coats are only cured at 100°C (10 min) and 200°C (10 min) each. This technique of using partially cured undercoats provides superior adhesion, better step coverage and higher planarity and is preferred over a single coat. Thickness of the coatings is controlled by selecting suitable viscosity of the polymer solution.

A layer 4 consists of an organic polymer as a polysulfone, polycarbonate or a polyimide which is thermally stable to 300°C but is soluble in solvents which do not dissolve the underlayer 3 of duPont polyimide RC-5878 which is retained in the final structure as an interlevel dielectric. Also, the material of layer 4 should be relatively insensitive to any stray or backscattered electrons. Typical materials for layer 4 are Ciba Geigy polyimide UX218 duPont polyimide and ICI polysulfone 100-P. The use of this polysulfone is described in U.S. Patent 4,367,119. The thickness of this layer 4 is typically in the range of 0.3 to 2.5 μm (microns) more preferably 0.3 to 1 micron for integrated circuit applications and 1—2.5 microns for packaging.

Layer 5 can be of any suitable material resistant to oxygen reactive in etching. Preferred material used for layer 5 is $SiO_x$ deposited by evaporation or by plasma enhanced chemical vapor deposition (CVD). However, inorganic materials $SiO_2$, $Al_2O_3$, Si, $Si_xN_yH_z$ and organometallics such as resin glass or plasma deposited organosilicons covered in the copending application can also be used. A layer 6 of a photoresist is then deposited on 5, exposed and developed according to well established technology. As shown in Fig. 3, via holes are then formed by removing the exposed portions of layers 5, 4 and 3 giving vertical walls with 4 and 3 undercut from layer 5 (Fig. 3). The preferred method for removing the patterned portion of the three layers is reactive ion etching. Preferred apparatus for this is given in U.S. Patent 3,985,597.

For removing $SiO_x$ and the two organic under layers, the methodology is described in U.S. Patent 4,367,119.

As indicated in Fig. 4, a metallic layer 7 is then deposited by evaporation on the top surface of 5 which also results in deposition of 7 through the openings. The thickness of 7 is approximately equal to that of 3. The conductive metal of layer 7 can be aluminum, aluminum/copper alloys, tantalum, molybdenum or laminated combination such as chromium-copper-chromium, chromium-silver-chromium, Al-Ti-Si and the like.

As shown in Fig. 5, film 4 and all the layers above 11 are next removed by exposing the substrate to a solvent in which the material of layer 4 is soluble. In the case of ICI polysulfone 100-P, the preferred solvent is NMP at 60—85°C. Ultrasonic agitation facilitates the lift-off. Essentially planar metal patterns surrounded by 3 are obtained by this technique. The small gaps or spaces 8 are filled with the polyimide used for 3 or any other suitable resin plastic when the second sequence of steps is used to form the next level of metallurgy. Again, it is preferred to apply the duPont polyimide RC-5878 layer in two coats to achieve gap filling and higher planarization.

The most important departure from the previous art is the use of plasma polymerized organosilicon layer (about 70—200 nm) over thermosetting resin layer 3'. The preferred material of 3' is duPont polyimide RC-5878 used as interlevel dielectric shown in Fig. 6. It is understood that while polyimide RC-5878 is the preferred material, other thermally stable polymers could also be used.

The preferred material for the organosilicon layer 9 is the plasma polymerized divinyltetramethyl disiloxane (DVS) or hexamethyl disilazane (HMDS). These monomers are commercially available. Other organosilicons covered in the copending application can also be used for this layer. The monomers can be deposited in an inductively or a capacitively coupled plasma apparatus. Using plasma enhanced chemical vapor deposition (PECVD) tool equipped with heating capability, films are typically deposited at 100—150°C at 25—500 watts RF power at 50 KHz depending on the gas flow and the reactor configuration. The deposited films are preferably annealed at 250—400°C for 10—30 minutes under nitrogen. Annealing improves mechanical integrity of the films and adhesion with the polyimide underlayer 3'. In an inductively coupled apparatus operating at 13.56 MHz, the films deposited at room temperature and then annealed at 250—400°C as above perform equally well. The plasma deposition can be carried out in the presence of a carrier gas such as helium or argon which yields films with higher density. Thickness of the plasma deposited film generally is 100—250 nm. In a typical conventional PECVD reactor supplied by Applied Materials, Inc. with 50,8 cm (20") diameter parallel plate set-up, the following set of conditions give usable films of divinyltetramethyl disiloxane (DVS) or hexamethyldisilazane (HMDS).

| | |
|---|---|
| HMDS | 200 SCCM |
| Argon | 800 SCCM |
| RF | 50 KHz |
| Power | 100 watts or 0.28 watt/cm$^2$ |
| Substrate temperature · | 100°C |
| Total flow | 1000 SCCM |

| Total pressure | 33,33 µbar (25 microns) |
| Deposition rate | 17.5 nm per minute. |

In another system operated at 13.56 MHz using 40,64 cm (16″) diameter parallel plate using a gas pressure of 33,33—46,66 µbar (25—35 microns), divinyltetramethyl disiloxane (DVS) gives excellent films deposited at 22.5 nm/minute. The films were annealed at 250—400°C for 10 minutes before applying the polysulfone layer 6′.

In equipment run in inductive mode the samples are placed downstream in a chamber close to the end of the glow discharge tube and the samples are gently rotated (6 revolutions/min). DVS could be deposited at a rate of 6—7 nm using 5—15 watts power. For HMDS higher power (15—25 watts) is required to give a deposition rate of 5—6 nm per minute. The films are preferably annealed at 250—400°C (10—15 min) before coating the next layer 4′.

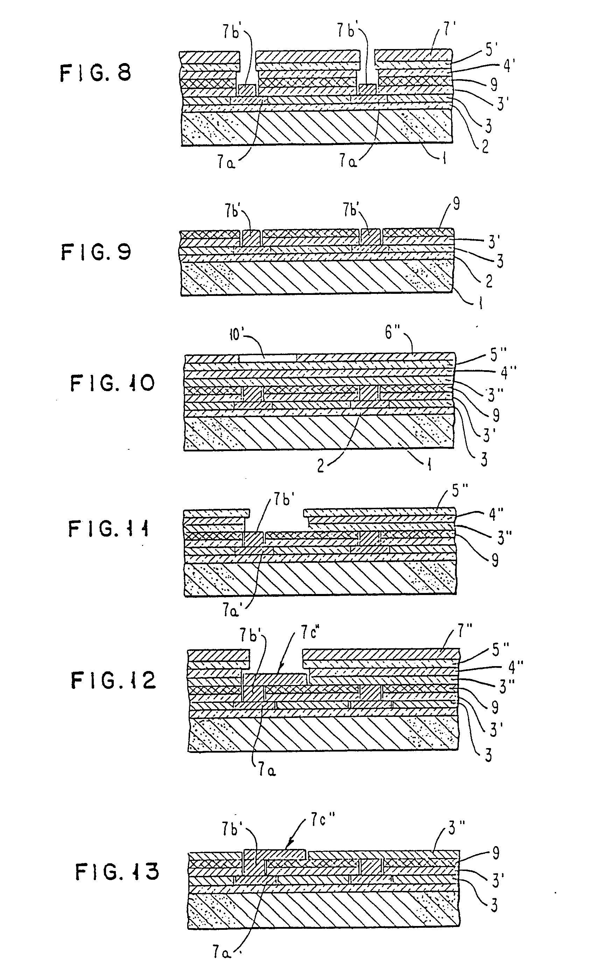

The layers 4′, 5′, in Fig. 6 correspond respectively to layers 4 and 5 in Fig. 2. A layer of photoresist 6′ is then deposited on 5′ and patterned suitably to furnish the via hole pattern 10 (Fig. 7) after sequentially developing the resist layer 6′, reactive ion etching of 5′ with $CF_4$ ambient, 4′ with $O_2$ ambient, 9 again with $CF_4$ or a mixture of $O_2+CF_4$ in the ratio of 5:95 and finally with $O_2$ again to make contact with the metal 7a. At this stage it is advisable to institute a sputter clean step using argon ions for 20—30 seconds or buffered HF cleaning for 5—10 seconds in order to remove any residue left on the metallurgy 7a. Metal is then blanket deposited leading to the formation of the studs 7b′ in contact with metallurgy 7a to give the structure represented by Fig. 8. It must be noted here if an inorganic oxygen RIE barrier $Si_3N_4$ as described in U.S. Patent 4,367,119 is used in place of plasma deposited organosilicon layer 9 there is a higher tendency towards conical stud formation instead of the desired planar ones 7b′ and 7b′ shown in Fig. 8. The organometallic film 9 used here being more permeable to gases alleviates the conical stud formation as gases or vapors now can escape throughout 9 at a higher rate during metal evaporation (at 250—300°C) than being forced to escape mostly through the via holes when $Si_3N_4$ is used.

It is also to be noted here that the organosilicon film 9 serves as $O_2$ RIE stop which precludes any overetching of the underlayer 3′ of the polyimide. Further, since the material of 9 has good insulation properties, the metallurgy (7a+7b′) remains embedded in the dual insulation layers 3′ and 9 as shown (Fig. 9) after lift off as before.

The sequence of process steps given above can be repeated to deposit the insoluble polyimide (e.g. duPont polyimide RC-5878) layer 3″, the solvent soluble lift off layer 4″ (e.g. ICI polysulfone, Ciba Geigy polyimide XU218) and the oxygen etch resistant mask layer 5″ (e.g. $SiO_x$) and an overlying resist layer 6″ which is suitably patterned with openings 10′ by optical, e-beam, x-ray, ion beam or deep UV lithographic techniques (Fig. 10).

After RIE of 5″ ($SiO_x$) in a $CF_4$ ambient, sequential RIE in oxygen ambient is accomplished of the soluble layer 4″ of polysulfone and the insoluble polyimide layer 3″. As shown in Fig. 11 the oxygen RIE is stopped at the etch stop dielectric layer 9 which protects the structure from any over etching or thinning of the insoluble polyimide underlayer 3′. The organosilicon layer 9 serves as an etch stop during RIE at the metal levels for interconnection of multilevel metallization. This enhances process tolerance for the RIE and permits rigorous removal of the oxygen etchable material from the patterned area 10′ with built in safety against overetching or thinning of interlevel dielectric layer 3′ and thereby prevents interlevel shorts. As shown in Fig. 11, after forming the patterned openings on the second level of conducting metal (e.g. Al or Cu) layer 7″ is blanket deposited inclusive of the patterned openings (e.g. by e-beam evaporation) shown in Fig. 12. This is followed by a lift-off through dissolution of the soluble layer 4″ which carries away with it the overlying layers 5″ and portions of 7″ contacting it. This results in the formation of a second level of metallization with the addition of pattern 7c″ (Fig. 13) interconnected through stud 7b′ to the first level metal 7a. It should be noted here the above sequence of steps coupled with the choice of specific materials and process conditions results in a structure (Fig. 13) with two levels of interconnected metallurgy without danger of interlevel shorts due to the interposition of the two dielectric layers viz polyimide 3′ and plasma deposited organosilicon layer 9. The latter also serves as an etch stop which reduces interlevel defects by preventing thinning or overetching of the polyimide insulator 3′.

It will be clear to those skilled in the art that the above steps can be repeated over and over again to form a number of levels of metallurgy with interconnections as desired.

**Claims**

1. In an integrated circuit package having a substrate with a conductive interconnective first pattern (7a) on a surface thereof, a layered composite structure on the surface of said substrate comprising:

a first layer (3′) of an organic polymer electrical insulator overlying said surface and said first pattern (7a); and

a covering organosilicon insulating layer being resistant to reactive ion etching in an $O_2$ atmosphere (9) and overlying said polymer layer (3′); and

a second conductive pattern (7c″) on said organosilicon insulating layer (9); and

there being at least one via opening (10) through said composite layered structure to a portion of said first pattern (7a); and

conductive metallurgy (7b′) in said via opening (10) interconnecting the said first pattern (7a) and said second pattern (7c″).

2. Structure according to claim 1 wherein the material of said organosilicon insulating layer (9) is selected from the group consisting of plasma polymerized divinyl tetramethyl disiloxane, hexamethyl disilazane, divinyltetramethyl disilazane, trivinyl penta methyl trisiloxane, vinyl trimethoxysilane and hexamethyl disiloxane.

3. Structure according to claim 1 or 2 wherein said organic layer (3') consists of polyimide.

4. Method of forming superposed levels of metallurgy in the fabrication of an integrated circuit package where said method starts from a substrate having a conductive interconnected pattern (7a) on a surface thereof and comprises the following steps in the following sequence:

A) forming a first layer (3') of an electrically insulating polymer on said surface

B) coating said first layer (3') with a second layer (9) of a plasma deposited organosilicon insulating material selected from the group consisting of divinyl tetramethyl disiloxane, hexamethyl disilazane, hexamethyl disiloxane, divinyl tetramethyl disilazane, trivinyl penta methyl trisiloxane or vinyl trimethoxysilane

C) coating said second layer (9) with a third layer (4') of a polymer that is selectively soluble in solvent to which the first said polymer is inert

D) coating said third layer (4') with a fourth layer (5') resistant to reactive ion etching in oxygen ambient

E) forming on said fourth layer (5') a resist mask (6') defining at least one via opening (10) to a portion of said conductive pattern (7a)

F) reactive ion etching in $CF_4$ ambient the exposed portion of said fourth layer (5') in said via opening (10)

G) reactive ion etching in an oxygen ambient portions of said third layer (4') in said via opening (10)

H) reactive ion etching in a $CF_4$ or $CHF_3$ or mixture of $CF_4$ and $O_2$ ambient the exposed portions of said second layer (9) in said via opening (10)

I) reactive ion etching in $O_2$ ambient the exposed portion of said first layer (3') in said via opening (10) to expose said portion of said conductive pattern

J) blanket coating said substrate inclusive of said via opening (10) with a conductive metal layer (7') having a thickness close to the said first layer (3')

K) exposing said substrate to said solvent for a time sufficient to remove said third layer (4') and all overlying layers thereon, to expose the plasma deposited organosilicon insulating layer (9) and said metal via connection (7b) in said via opening (10)

L) sequentially coating said plasma deposited organosilicon layer with fifth, sixth and seventh layer (3", 4" or 5" respectively) corresponding respectively to the composition of said first, third and fourth layer (3', 4 or 5' respectively)

M) forming a second resist mask (6") having openings (10') corresponding to desired metallurgy patterns (7c) to be deposited on said plasma deposited organosilicon second layer (9), said opening encompassing said via connector (7b') and adjacent discrete areas of said plasma deposited second organosilicon layer (9)

N) reactive ion etching in an ambient of $CF_4$ the exposed portions of said seventh layer (5") in the openings of said second resist mask (6")

O) sequentially reactive ion etching in $O_2$ ambient said sixth layer (4") and said fifth layer (3") in opening (10') of said second resist mask (6"), to expose said via connector (7b') and adjacent portions of said plasma deposited organosilicon second layer (9)

P) depositing a blanket coating of a conductive metal (7") over said substrate inclusive of said via connector (7b') and said adjacent exposed portion of said plasma deposited organosilicon layer (9)

Q) exposing said substrate to a solvent selective to the said sixth layer (4") for a time sufficient to remove said sixth layer (4") including overlying layers thereon.

5. Method according to claim 4 wherein multiple interconnecting levels of metallurgy are formed by repeating the sequence of process steps A through Q.

6. Method according to claim 4 or 5 wherein said first layer (3') is a polyimide.

7. Method according to any one of claims 4 to 6 wherein said third layer (4') is a polysulfone.

8. Method according to any one of claims 4 to 7 wherein said fourth layer (5') is $SiO_x$ or plasma deposited organosilicon.

9. Method according to any one of claims 4 to 8 wherein said conductive metal (7', 7") is an aluminum copper alloy.

**Patentansprüche**

1. In einer integrierten Schaltungspackung mit einem Substrat, mit einem ersten leitenden Verbindungsmuster (7a) auf der Oberfläche und mit einer geschichteten Verbundstruktur auf der Oberfläche des Substrats, folgendes enthaltend:

eine erste Schicht (3') eines aus einem organischen Polymer bestehenden elektrischen Isolators über der Oberfläche und dem ersten Muster (7a), sowie

eine Organosilikon-Isolierdeckschicht, welche von reaktivem Ionenätzen in einer $O_2$ Atmosphäre (9) nicht angegriffen wird und über der Polymerschicht (3') aufgebracht ist, sowie

ein zweites leitendes Muster (7c") auf der isolierenden Organosilikonschicht (9), wobei

die geschichtete Verbundstruktur mindestens eine Durchgangsöffnung (10) zu einem Teil des ersten Musters (7a) aufweist, und wobei eine leitende Metallisierung (7b') in den Öffnungen (10) das erste Muster (7a) und das zweite Muster (7c") miteinander verbindet.

2. Struktur nach Anspruch 1, bei der das Material der isolierenden Organosilikonschicht (9) aus der Gruppe von plasmapolymerisiertem Divinyl-Tetramethyldisiloxan, Hexamethyldisilazan, Divinyltetramethyl-Disilazan, Trivinyl-Pentamethyl-Trisiloxan, Vinyltrimethoxysilan und Hexamethyldisiloxan gewählt ist.

3. Struktur nach Anspruch 1 oder 2, bei der die organische Schicht (3') aus Polyimid besteht.

4. Verfahren zum Bilden übereinanderliegender Metallisierungsniveaus bei der Herstellung einer integrierten Schaltungspackung, welches von einem Substrat mit einem leitenden Verbindungsmuster (7a) auf der Oberfläche ausgeht und folgende Schritte in folgender Reihenfolge umfaßt:

A) Ausbilden einer ersten Schicht (3') eines elektrisch isolierenden Polymers auf der Oberfläche,

B) Beschichten der ersten Schicht (3') mit einer zweiten Schicht (9) eines im Plasma aufgebrachten Organosilikon-Isoliermaterials aus der Gruppe von Divinyl-Tetramethyldisiloxan, Hexamethyldisilazan, Hexamethyldisiloxan, Divinyl-Tetramethyldisilazan, Trivinyl-Pentamethyl-Trisiloxan oder Vinyltrimethoxysilan,

C) Überziehen der zweiten Schicht (9) mit einer dritten Schicht (4') eines Polymers, das selektiv in einem Lösungsmittel löslich ist, zu welchem sich das erste Polymer inert verhält,

D) Überziehen der dritten Schicht (4') mit einer vierten Schicht (5'), die gegen reaktives Ionenätzen in einer Sauerstoffumgebung resistent ist,

E) Herstellen einer Resistmaske (6'), welche mindestens eine Durchgangsöffnung (10) zu einem Teil des leitenden Musters aufweist, auf der vierten Schicht (5'),

F) reaktives Ionenätzen in einer CF₄-Umgebung des in der Durchgangsöffnung (10) freiliegenden Teils der vierten Schicht (5'),

G) reaktives Ionenätzen in einer Sauerstoffumgebung von in der Durchgangsöffnung (10) freiliegenden Teilen der dritten Schicht (4'),

H) reaktives Ionenätzen in einer Umgebung von CF₄ oder CHF₃ oder einer Mischung von CF₄ und O₂ der in der Durchgangsöffnung (10) freiliegenden Teile der zweiten Schicht (9),

I) reaktives Ionenätzen in einer O₂-Umgebung des in der Durchgangsöffnung (10) freiliegenden Teils der ersten Schicht (3') zum Freiliegen des leitenden Musters im Bereich der Durchgangsöffnung,

J) Flächenbeschichtung des Substrats einschließlich der Durchgangsöffnung (10) mit einer leitenden Metallschicht (7'), deren Stärke der ersten Schicht (3') nahekommt,

K) Aussetzen des Substrats dem Lösungsmittel während einer Zeitspanne, welche zur Entfernung der dritten Schicht (4') und aller sich darauf befindenden Schichten und zum Freilegen der im Plasma aufgebrachten Organosilikon-Isolierschicht (9) und der Metalldurchführung (7b) in der Durchgangsöffnung (10) ausreicht,

L) aufeinanderfolgendes Überziehen der im Plasma aufgebrachten Organosilikonschicht mit einer fünften, sechsten und siebten Schicht (3", 4" bzw. 5"), deren Zusammensetzung jeweils der der ersten, dritten und vierten Schicht (3', 4' bzw. 5') entspricht,

M) Herstellen einer zweiten Resistmaske (6") mit mindestens einer Öffnung (10'), welche einem gewünschten Metallisierungsmuster (7c) entspricht, das auf der zweiten im Plasma niedergebrachten Organosilikonschicht aufzubringen ist, wobei die Öffnung die Durchführung (7b') und benachbarte diskrete Bereiche der zweiten im Plasma aufgebrachten Organosilikonschicht (9) umfaßt,

N) reaktives Ionenätzen in einer Umgebung von CF₄ in den Öffnungen der zweiten Resistmaske (6") der freiliegenden Teile der siebten Schicht (5"),

O) aufeinanderfolgendes reaktives Ionenätzen in einer O₂ Umgebung in der Öffnung (10') der zweiten Resistmaske (6") der sechsten Schicht (4") und der fünften Schicht (3") zum Freilegen der Durchführung (7b') und benachbarter Bereiche der zweiten im Plasma aufgebrachten Organosilikonschicht (9),

P) Aufbringen einer ganzflächigen Beschichtung eines leitenden Metalls (7") auf dem Substrat einschließlich der Durchführung (7b') und den benachbarten freigelegten Bereich der im Plasma niedergebrachten Organosilikonschicht (9),

Q) Aussetzen des Substrats einem Lösungsmittel, das auf die sechste Schicht (4") während einer Zeit selektiv wirkt, die zum Entfernen dieser sechsten Schicht (4") mit darauf befindlichen Schichten ausreicht.

5. Verfahren nach Anspruch 4, bei dem eine Vielzahl von untereinander verbundenen Metallisierungsniveaus durch die Wiederholung der Folge von Verfahrensschritten A bis Q hergestellt werden.

6. Verfahren nach den Ansprüchen 4 oder 5, bei dem die erste Schicht (3') ein Polyimid ist.

7. Verfahren nach einem der Ansprüche 4 bis 6, bei dem die dritte Schicht (4') ein Polysulfon ist.

8. Verfahren nach einem der Ansprüche 4 bis 7, bei dem die vierte Schicht (5') SiO$_x$ oder ein im Plasma aufgebrachtes Organosilikon ist.

9. Verfahren nach einem der Ansprüche 4 bis 8, bei dem das leitende Metall (7', 7") eine Aluminiumkupferlegierung ist.

**Revendications**

1. Module de circuit intégré comprenant un substrat dont une surface comporte un premier dessin d'interconnexions conducteur (7a), cette structure comprenant:

une première couche (3') d'un isolant électrique en polymère organique recouvrant cette surface et ce premier dessin (7a); et

une couche isolante de recouvrement en organosilicium, résistante à la gravure par ions réactifs dans une atmosphère de O₂ (9) et recouvrant la couche de polymère (3'); et

un deuxième dessin conducteur (7c") sur la couche isolante d'organosilicium (9); et

au moins une ouverture de passage (10) traversant la structure à couches composite jusqu'à une partie du premier dessin (7a); et

une métallisation conductrice (7b"), dans l'ouverture de passage (10), établissant une interconnexion entre le premier dessin (7a) et le deuxième dessin (7c").

2. Structure selon la revendication 1, dans laquelle le matériau de la couche isolante d'organosilicium (9) est choisi dans le groupe constitué par le divinyltétraméthyldisiloxane, l'hexaméthyldisilazane, le divinyltétraméthyldisilazane, le trivinylpentaméthyltrisiloxane, le vinyltriméthoxysilane et l'hexaméthyldisiloxane polymérisés par plasma.

3. Structure selon la revendication 1 ou 2, dans laquelle la couche organique (3') est constituée de polyimide.

4. Procédé de formation de niveaux superposés de métallisation dans la fabrication d'un module de circuit intégré, ce procédé partant d'un substrat, dont une surface comporte un dessin d'interconnexions conducteur (7a), et comprenant les étapes suivantes, dans l'ordre suivant:

A) former sur la surface une première couche (3') d'un polymère isolant électriquement

B) revêtir cette première couche (3') d'une deuxième couche (9) d'un matériau isolant d'organosilicium déposé par plasma, choisi dans le groupe du divinyltétraméthyldisiloxane, de l'hexaméthyldisilazane, de l'hexaméthyldisiloxane, du divinyltétraméthyldisilazane, du trivinylpentaméthyltrisiloxane ou du vinyltriméthoxysilane,

C) revêtir la deuxième couche (9) d'une troisième couche (4') d'un polymère qui est sélectivement soluble dans un solvant vis-à-vis duquel le premier polymère est inerte,

D) revêtir la troisième couche (4') d'une quatrième couche (5') résistante à la gravure par ions réactifs dans une atmosphère d'oxygène,

E) former sur la quatrième couche (5') un masque de résine photorésistante (6') définissant au moins une ouverture de passage (10) vers une partie du dessin conducteur (7a),

F) graver par ions réactifs, dans une atmosphère de CF$_4$, la partie exposée de la quatrième couche (5') dans l'ouverture de passage (10),

G) graver par ions réactifs, dans une atmosphère d'oxygène, les portions de la troisième couche (4') dans l'ouverture de passage (10),

H) graver par ions réactifs, dans une atmosphère de CF$_4$ ou de CHF$_3$, ou dans une atmosphère constituée d'un mélange de CF$_4$ et de O$_2$, les parties exposées de la deuxième couche (9) dans l'ouverture de passage (10),

I) graver par ions réactifs, dans une atmosphère de O$_2$, la partie exposée de la première couche (3') dans l'ouverture de passage (10), pour exposer la partie du dessin conducteur,

J) recouvrir le substrat, y compris l'ouverture de passage (10), d'une couche de métal conducteur (7') ayant une épaisseur proche de celle de la première couche (3'),

K) exposer le substrat au solvant pendant un temps suffisant pour éliminer la troisième couche (4') et toutes les couches qui la recouvrent, pour exposer la couche isolante d'organosilicium (9) déposée par plasma et la connexion de passage métallique (7b) dans l'ouverture de passage (10),

L) revêtir successivement la couche d'organosilicium déposée par plasma de la cinquième, la sixième et la septième couche (respectivement 3", 4" ou 5"), correspondant respectivement à la composition de la première, troisième et quatrième couche (respectivement 3', 4' ou 5'),

M) former un deuxième masque de résine photo-résistante (6") comportant des ouvertures (10') correspondant aux dessins de métallisation (7c) souhaités à déposer sur la seconde couche (9) d'organosilicium déposée par plasma, l'ouverture englobant le connecteur de passage (7b') et les zones discrètes adjacentes de la deuxième couche d'organosilicium (9) déposée par plasma,

N) graver par ions réactifs, dans une atmosphère de CF$_4$, les parties exposées de la septième couche (5") dans les ouvertures du deuxième masque de résine photorésistante (6"),

O) graver successivement par ions réactifs, dans une atmosphère de O$_2$, la sixième couche (4") et la cinquième couche (3") dans l'ouverture (10') du deuxième masque de résine photo-résistante (6"), pour exposer le connecteur de passage (7b') et les parties adjacentes de la deuxième couche d'organosilicium (9) déposée par plasma,

P) déposer un revêtement d'un métal conducteur (7") par-dessus le substrat, y compris le connecteur de passage (7b') et la partie exposée adjacente de la couche d'organosilicium déposée par plasma (9),

Q) exposer le substrat à un solvant sélectif vis-à-vis de la sixième couche (4"), pendant un temps suffisant pour éliminer la sixième couche (4"), y compris les couches qui la recouvrent.

5. Procédé selon la revendication 4, dans lequel on forme des niveaux multiples d'interconnexions des métallisations en répétant la séquence des étapes du procédé A à Q.

6. Procédé selon la revendication 4 ou 5, dans lequel la première couche (3') est un polyimide.

7. Procédé selon l'une quelconque des revendications 4 à 6, dans lequel la troisième couche (4') est une polysulfone.

8. Procédé selon l'une quelconque des revendications 4 à 7, dans lequel la quatrième couche (5') est SiO$_x$ ou un organosilicium déposé par plasma.

9. Procédé selon l'une quelconque des revendications 4 à 8, dans lequel le métal conducteur (7', 7") est un alliage d'aluminium et de cuivre.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13